# EUROPEAN PATENT APPLICATION

(11) **EP 3 410 208 A1**
(43) Date of publication of application: **05.12.2018**
(21) Application number: 17173948.5
(22) Date of filing: 01.06.2017
(51) Int. Cl.: G03F 7/004, H01L 51/52, H05B 33/12, H01L 51/56

(54) **DEVICE CONTAINING METAL OXIDE-CONTAINING LAYERS**

(71) Applicant: Evonik Degussa GmbH, 45128 Essen (DE)
(72) Inventor: STEIGER, Jürgen, 64285 Darmstadt (DE); MERKULOV, Alexey, 45772 Marl (DE); ANSELMANN, Ralf, 59348 Lüdinghausen (DE); RENNER, Gerhard, 64589 Stockstadt am Rhein (DE)

(57) **Abstract**

The present invention is directed to a method for preparing a device, the method comprising: forming a first layer on top of a first electrode, the layer comprising a metal oxide that is formed by the deposition of a metal oxide precursor composition that can be directly patterned by means of exposure to electromagnetic radiation to form a patterned metal oxide layer, optionally forming a second electrode over the first device layer, wherein the method further includes optionally forming a layer comprising quantum dots on top of the first layer or after formation of the first layer, and to a device comprising a first layer comprising a metal oxide prepared by the method of the invention.

## Description

The present invention is directed to a method for preparing a device, the method comprising: forming a first layer on top of a first electrode, the layer comprising a metal oxide that is formed by the deposition of a metal oxide precursor composition that can be directly patterned by means of exposure to electromagnetic radiation to form a patterned metal oxide layer, optionally forming a second electrode over the first layer, wherein the method further includes optionally forming a layer comprising quantum dots on top of the first layer or after formation of the first layer, and to a device comprising a first layer comprising a metal oxide prepared by the method of the invention. In the present invention the terms "device layer" and "layer" are used interchangeable.

### Technical field of the invention

The invetion is related to the technical field of devices that comprise a layer comprising a metal oxide that is formed by the deposition of a metal oxide precursor composition, preferably light emmitting layers, and more preferably comprise quantum dots.

### Summary of the invention

In accordance with one aspect of the present invention there is provided a method for preparing a device, the method comprising:
forming a first layer on top of a first electrode, the layer comprising a metal oxide that is formed by the deposition of a metal oxide precursor composition that can be directly patterned by means of exposure to electromagnetic radiation to form a patterned metal oxide layer, optionally forming a second electrode over the first layer, wherein the method further includes optionally forming a layer comprising quantum dots on top of the first layer or after formation of the first layer. The method preferably further includes forming a layer comprising quantum dots over the first electrode before or after the formation of the first layer. Preferred metal oxides for the inclusion in the first layer comprise indium oxide, zinc oxide, gallium oxide, yttrium oxide, tin oxide, germanium oxide, scandium oxide, titanium oxide, zirconium oxide, aluminum oxide, wolfram oxide, molybdenum oxide, nickel oxide, chromium oxide, iron oxide, hafnium oxide, tantalum oxide, niobium oxide and copper oxide, and mixtures thereof.

The first layer can preferably is a charge transport layer. For example, the first layer may comprise a material capable of transporting electrons (also referred to herein as an electron transport layer). The first layer can comprise a material capable of transporting electronics and injecting electrons (also referred to herein as an electron transport and injection layer). The first layer can comprise a material capable of transporting holes (also referred to herein as hole transporting layer). The first layer can comprise a material capable of transporting holes and injecting holes (also referred to herein as a hole transport and injection layer).

The method preferably further includes forming a second layer (e.g. a second charge transport layer). The second layer is preferably formed such that the layer comprising the quantum dots is disposed between the first and second device layer.

Advantageously, the present methods include the formation of a first layer that is formed by the deposition of a metal oxide precursor composition that can be directly patterned by means of exposure to electromagnetic radiation to form the patterned metal oxide layer. Direct patterning of the device layer is advantageous for the processing of light emitting devices.

One of the electrodes may be formed on a substrate on which the device is build.

The method optionally further comprises formation of other optional layers, including, for example, but not limited to, charge blocking layers, charge injection layers, charge confinement layers, exciton confinement layers, etc., in the device, which can be patterned or unpatterned.

The device preferably is a light-emitting device wherein a layer is present that comprises quantum dots.

In accordance with a second aspect of the present invention, there is provided a device prepared by the method taught herein.

The device according to the invention comprises a first layer formed on top of a first electrode, the first layer comprising a metal oxide that is formed by the deposition of a metal oxide precursor composition that can be (directly) patterned by means of exposure to electromagnetic radiation to form a patterned metal oxide layer, a second electrode layer on top of the first layer, and a layer comprising quantum dots disposed between the first device layer and one of the two electrodes.

Preferred metal oxides for inclusion in the first layer include zinc oxide, titanium oxide, indium oxide, gallium oxide, tin oxide, aluminum oxide, hafnium oxide, yttrium oxide, germanium oxide zirconium oxide, nickel oxide, copper oxide, tantalum oxide, niobium oxide, scandium oxide and mixtures thereof.

The first layer can be a charge transport layer. For example, the first layer may comprise a material capable of transporting electrons (also referred to herein as an electron transport layer). The first device layer may comprise a material capable of transporting electrons and injecting electrons (also referred to herein as an electron transport and injection layer). The first device layer may comprise a material capable of transporting holes and injecting holes (also referred to herein as a hole transport and injection layer). The device may further include a second layer (e.g. a charge transport layer) such that the layer comprising quantum dots is disposed between the first and second layers. The second layer can be patterned or unpatterned.

The device may further include a substrate. For example, the first or second electrode may be formed on a substrate.

The substrate may be selected from: glass, plastic, quartz, metal foil, silicon wafer (doped or undoped). Other substrate materials may be used. Plastic can comprise PE, PP, PET, PEN, Polyimide, PEEK, Polyamide. The substrate may be a flexible substrate.

The device according to the invention may further comprise other optional layers, including, for example, but not limited to, charge blocking layers, charge injecting layers, charge confinement layers, exciton confinement layers, etc.

Preferrably the device of the invention is a light-emitting device. In this event the layer comprising quantum dots preferably comprises an emissive material.

The foregoing, and other aspects described herein, all constitute embodiments of the present invention.

It should be appreciated by those persons having ordinaiy skill in the art(s) to which the present invention relates that any of the features described herein in respect of any particular aspect and/or embodiment of the present invention can be combined with one or more of any of the other features of any other aspects and/or embodiments of the present invention described herein, with modifications as appropriate to ensure compatibility of the combinations. Such combinations are considered to be part of the present invention contemplated by this disclosure.

It is to be understood that both the foregoing general description and the following detailed description are exemplary and explanatory only and are not restrictive of the invention as claimed.

Other embodiments will be apparent to those skilled in the art from consideration of the description and drawings, from the claims, and from practice of the invention disclosed herein.

In the drawings:

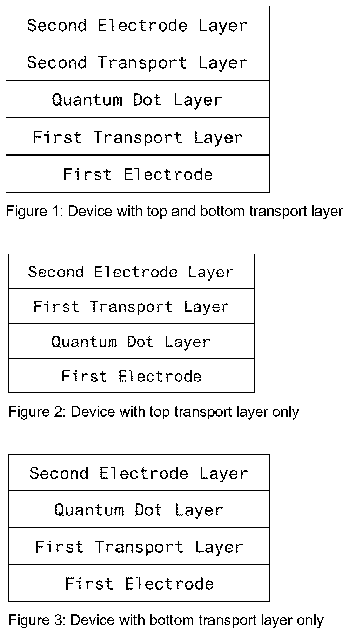

Figure 1: Depicts a device structure in accordance with the present invention.
Figure 2: Depicts a device structure in accordance with the present invention with top only configuration.
Figure 3: Depicts a device structure in accordance with the present invention with bottom only configuration.
Figure 4: Depicts a device in accordance with the present invention. 10 is the device, 6 substrate, 5 first electrode (layer), 4 first transport layer, 3 quatum dot emitter layer, 2 second transport layer, 1 second electrode (layer).
Figure 5: Depicts an example of a device with patterned transport layers.

The attached figures are simplified representations presented for purposes of illustration only; actual structures may differ in numerous respects, including, e.g., relative scale, etc.

For a better understanding to the present invention, together with other advantages and capabilities thereof, reference is made to the following disclosure and appended claims in connection with the above- described drawings.

### Background of the Invention

Indium oxide (indium(III) oxide, In₂O₃), owing to the large band gap between 3.6 and 3.75 eV (measured for vapor-deposited layers) [H.S. Kim, P.D. Byrne, A. Facchetti, T.J. Marks; J. Am. Chem. Soc. 2008, 130, 12580-12581], is a promising semiconductor for charge transport in thin films. Thin films of a few hundred nanometers in thickness may additionally have a high transparency in the visible spectral range of greater than 90% at 550 nm. The transparency makes such thin films interesting candidates for thin devices that emit light.

Indium oxide is often used in particular together with tin(IV) oxide (SnO₂) as the semi conductive mixed oxide ITO. Owing to the comparatively high conductivity of ITO layers with the same transparency in the visible spectral range, one application thereof is in the field of liquid-crystal displays (LCDs) and organic light emitting diodes (OLEDs) as well as quantum dot light emitting diodes (QD LEDs), especially as a "transparent electrode". These usually doped metal oxide layers are produced industrially in particular by costly vapor deposition methods under high vacuum.

In addition to metal oxide-containing layers, especially indium oxide-containing layers and the production thereof, and among these ITO layers and pure indium oxide layers, are thus of great significance for the semiconductor and display industry.

V. Wood, M.J. Panzer, J.E. Halpert, J.-M. Caruge, M.G. Bawendi, V. Bulociv; ACS Nano, Vol. 3, No. 11, pages 3581 - 3586 describe the use of transparent ITO as conductive layer, together with nickel oxide, tungsten oxide, tin oxide, zinc tin oxide and zinc oxide for use as hole and electron transport layers in a light emitting flat device that uses quantum dots for the generation of the emitted light. In this publication the use of metal sulfides, such as Zinc Cadmium Sulfide and Zinc Sulfide is also described for use in flat light emitting devices that use quantum dots as emitters. The deposition of the transport layers is done without patterning.

In addition to indium oxide-containing layers, especially nickel oxide, tungsten oxide, tin oxide, zinc tin oxide and zinc oxide containing layers and production thereof are thus of great significance for the semiconductor and display industry.

For flat light emitting devices that are used for display applications, the generation of red, green and blue colors is often desired. The emitting layers which are used for the generation of red, green and blue emissions use at least a different emitter to emit red, green and blue light. The first layer that is used as a charge transport or injection layer that transports charges to the emission layer can be a common layer, meaning that it is the same layer for the red, green and blue emission layers, or it can be a non-common layer. Such non-common layers are layers that are used for at least one emitting layer, but it is not the same for all emitting layers.

Metal oxide layers can in principle be produced via different processes.

One means of producing metal oxide layers is based on sputtering techniques. However, these techniques have the disadvantage that they have to be performed under high vacuum. A further disadvantage is that the films produced therewith have many oxygen defects, which make it impossible to establish a controlled and reproducible stoichiometry of the layers and hence lead to poor properties of the layers produced. Further, these layers have to be patterned by means of an additional photo lithography process that adds additional costs to the manufacturing costs.

Another principle for producing metal oxide layers is based on chemical gas phase deposition. For example, it is possible to produce indium oxide-, gallium oxide- or zinc oxide-containing layers from precursors such as metal alkoxides or metal oxo alkoxides via gas phase deposition. For example US 6,958,300 B2 teaches using at least one metal organo oxide precursor (alkoxide or oxo alkoxide) of the generic formula M¹_{q}(O)ₓ(OR¹)_{y} (q = 1-2; x = 0-4, y = 1-8, M¹ = metal; e.g. Ga, In or Zn, R¹ = organic radical; alkoxide when x = 0, oxo alkoxide when ≥ 1) in the production of semiconductors or metal oxide layers by gas phase deposition, for example CVD or ALD. However, all gas phase deposition processes have the disadvantage that they require either i) in the case of a thermal reaction regime, the use of very high temperatures, or ii) in the case of introduction of the required energy for the decomposition of the precursor in the form of electromagnetic radiation, high energy densities. In both cases, it is possible only with a very high level of apparatus complexity to introduce the energy required to decompose the precursor in a controlled and homogeneous manner. Further, these layers have to be patterned by means of an additional photo lithography process that adds additional costs to the manufacturing costs.

Patterning of such layers require additional process steps. These steps include, but are not limited to, coating the layer with a photoresist, exposure of the photoresist to electromagnetic radiation, developing of the photo resist, etching the layer (e.g. TMAH or KOH or other developers) and finally stripping the photo resist layer. This process requires the use of an additional photo sensitive layer and involves a very high level of apparatus complexity. Further it causes an increase of tact times in the production of the patterned layers.

Metal oxide layers that are formed from metal oxide precursors, which are used for many applications in the semiconductor and display industry, are usually patterned by means of a photo resist. This requires an increase in material use, a multitude of additional process steps and additional stress for the oxide layer, as well as any layers that have been applied prior to the metal oxide layer, by the exposure to the aggressive materials.

The direct patterning of metal oxide layers makes the use of photo resists obsolete. The state of the art describes four different methods for the direct patterning of metal oxide containing layers.

Cordonier et al., Langmuir, 2011, 27 (6), S. 3157-3156 describes the use of photo-acid generating ligands for indium oxide and titanium oxide precursors based on Catechol. The photoinduced splitting of the ligand releases an acid molecule, which causes in the irradiated region an increase in solubility compared to the non-exposed region. This allows the development of the layer like a positive resist type photo resist. The described method is technically complex to implement due to the necessity of synthesizing a ligand, which is fitting to the used metal oxide precursor.

Rim et al., ACS Nano, 2014, 8 (9), S. 9680-9686 describes compositions based on metal nitrates, which are used for the deposition of metal oxide containing layers and which can be made directly patternable by the addition of ammonium hydroxide and acetyl acetone to the metal center, which generates a photosensitive metal complex. The exposure to electromagnetic radiation initiates a polymerization, which causes a solubility difference between the exposed and non-exposed regions. In this case the photo sensitive composition reacts like a negative photo resist. Suitable metal oxide precursors are in this method strongly limited by the requirement of a ligand exchange with acetyl acetone.

JP 07258866 A describes a composition which allows a patterning by means of addition of water-releasing molecules, and, as an option, photo acid generating molecules. By polycondensations, which are facilitated by the release of water (and optional acid molecules), a solubility difference between the exposed and non-exposed regions is achieved. This method is limited by the requirement to use metal oxide precursors that allow a polycondensation.

DE 102013212018 A1 describes metal oxide precursors, which have a ligand that can be cross linked when exposed to electromagnetic radiation and a non-cross linkable ligand. A different in the solubility of the exposed and non-exposed regions of the layer is realized by a solubility difference that is caused by the polymerization of the irradiated ligands (negative resist). This method is limited by the availability of metal oxide precursors, which must be synthesized by a ligand exchange with ligands which can be polymerized, such as meth acrylic acid.

The object of the present invention was to provide a simple method for forming light emitting devices which overcome the limitation of the state of the art.

The task is solved by a method for preparing a device according to the claims, the method comprising forming a first layer, preferably a charge transport layer, over a first electrode, the layer comprising a metal oxide formed from a liquid phase composition for producing metal oxide-containing layers that can be patterned by means of exposure to electromagnetic radiation, wherein the composition is containing at least one metal oxide precursor, preferably comprising at least one metal atom from the group consisting of In, Zn, Ga, Y, Sn, Ge, Sc, Ti, Zr, Al, W, Mo, Ni, Cr, Fe, Hf, Ta, Nb and Cu, more preferably at least one metal from the group comprising In, Ga, Ge, Sn, Y and Zn and preferably comprising at least one ligand from the group of oxo-group, hydroxyl-group, alkoxy-group, carboxy-group, □-diketonate-group, halogenide-group, nitrate-group and secondary and primary amine-groups,
at least one photo acid generator, preferably an photo acid generator which upon exposure to electromagnetic radiation releases at least one acid molecule,
at least one solvent, preferably selected from the group comprising β-diketone ether alcohols, alcohol ethers and esters
and is used for forming the first layer.

Preferably the forming of the first layer is done by the following process steps
coating of the liquid phase composition on a surface,
exposure of the surface coated with the composition to electromagnetic radiation, preferably selected from UV-, IR, and/or VIS-radiation, more preferably selected from UV-radiation and
developing of the first layer,
with additional optional baking steps (thermal treatment steps) after any of the before mentioned steps. The thermal treatment steps might be done using conventional thermal sources like for example an oven and/or by using radiation, for example microwave radiation, UV-radiation, IRradiation or VIS-radiation (laser beam energy). Typically, thermal treatments times of a few seconds up to several hours are used. The thermal treatment (conversion) can additionally be promoted by treating the coated substrate with air or oxygen before, during or after the thermal treatment.

The quality of the layer obtained by the method according to the invention can additionally be improved further by a combined thermal and gas treatment (with H₂ or O₂), plasma treatment (Ar, N₂, O₂ or H₂ plasma), laser treatment (with wavelengths in the UV, VIS or IR range) or an ozone treatment, which follows the conversion step.
The invention further provides metal oxide-containing layers producible by means of the method according to the invention.

The compositions used in the method of the invention are characterized by at least one metal oxide precursor and at least one photo acid generator that are combined in the composition. According to the present invention, the photo acid generator is not part of one of the ligand of the metal oxide precursor, so that at no point in time during the preparation of the composition there exists a chemical bonding between the photo acid generating molecule and the metal oxide precursor. Preferably the molar ratio of the at least one photo acid generator to the metal oxide precursor in the composition is 1 to 1 to >1 to 1, preferably 1 to 1 to 5 to 1. Both components of the composition are available in suitable solvents. By the simple combination of a precursor and a photo acid generator the need for a complex synthesis of suitable ligands und the corresponding metal complexes is not required. The compositions according to the invention can thus more easily be adapted to the requirements for the film formation. Moreover, a multitude of developer solvents can be used for the development of the layer. The application of water sensitive layers, such as quantum dot layers, is possible, since the process does not require water containing compositions for the layer formation or developers for the layer development.

Compared to the state of the art the method of the present invention offers the following advantages:
- known precursors can be used without structural modifications. A complex synthesis of suitable ligands and metal complexes is not required.
- by the choice of the photo acid generators the wavelength of the electromagnetic irradiation, to which the composition is sensitive, can be selected.
- the method allows a broad usability by the combinatorial possibilities when combining a metal oxide precursor with a photo acid generator (and a developer).
- a direct patterning of the composition or the layer formed by the composition can be achieved with few process steps, which allows for time reductions and an increase in process reliability by the reduction of process complexity - without being limited to these positive effects.

A "metal atom" according to the current invention comprises a conducting metal atom as well as semi conducting metal atom. The same applies to conducting metal oxide layers and semi conducting metal atom layers that can be formed from these.

One advantage of the current invention and the compositions used is that common metal oxide precursor that are known in the state of the art can be used in the method of the invention.

In general there are no special limitation to the selection of precursors, as long as the precursors have at least one ligand, which can be modified from the precursor-bond by means of an acid elimination. By doing so a difference in the solubility of the intact and non-intact (i.e. after acid elimination) precursor can be achieved. Preferred precursors used in the method of the present invention are selected from the group consisting of [In₆O(OMe)₁₂Cl₆][NH₂Me₂]₂(MeOH)₂, Ga(acac)₃, Y₅O(OⁱPr)₁₃, Ge(OⁱPr)₄, In(NO₃)₃, InCl₃, Sn(O^{t}Bu)₄ und Zn(acac)₂.

The at least one photo acid generator that is used in the liquid phase composition is preferably a material, which releases upon exposure to electromagnetic radiation, preferably UV radiation, one or more acid molecules. The acid molecule may be an organic or inorganic molecule (mineral acid). Examples for organic acids include, but are not limited to carboxylic acid, sulfonic acid, phosphorous acid. Examples for mineral acids include, but are not limited to, hydrochloric acid, phosphoric acid sulfuric acid, hydrofluoric acid, nitric acid. The nomenclature of acid molecule includes in the context of the invention inorganic salts, which can form in protic solvents mineral acid molecules. As examples are, without limitation, PF₄⁻ und BF₄⁻ mentioned. The photo acid generator according to the present invention can be an ionic or nonionic compound. Generally suitable in the context of the present invention are all photo acid generators which fulfill the aforementioned criteria. Preferred examples which may be used in the present invention are, without limitation, photoacid generators selected from the group consisting of (Z) - [2- (propylsulfonyloxyimino) -3-thienylidene] (o-tolyl) acetonitrile), triphenylsulfonium triflate, diphenyliodonium nitrate, 1-hydroxycyclohexylphenyl ketone, 2-,2-hydroxy-1-[4-(2-hydroxyethoxy) phenyl]-2-methyl-1-propanone, methylbenzoyl formate, oxyphenylacetic acid 2-[2-oxo-2-phenylacetoxyethoxy] ethyl ester, oxyphenylacetic acid 2-[2-hydroxyethoxy] ethyl ester, 2,2-dimethoxy-2-phenylacetophenone, 2-benzyl-2-(dimethylamino)-1-[4-(4-morpholinyl) phenyl]-1-butanone, 2-methyl-1-[4-(methylthio)phenyl]-2-(4-morpholinyl)-1-propanone, diphenyl(2,4,6-trimethylbenzoyl)phosphine oxide, bis(2,4,6-trimethylbenzoyl) phenylphosphine oxide and mixtures of the abovementioned.

The active principle of the coating formulations (the liquid phase composition) according to the invention is based on the photoinduced cleavage of one or more acid molecules by at least one photo acid generator. According to the present invention, the photoacid generator and metal oxide precursors are formulated in combination with each other in the coating composition of the present invention but preferably are not chemically bonded, i.e. they are present as separate molecules in the coating composition. After the coating composition has been applied to the surface to be coated, acid molecules are released in the course of a subsequent exposure to radiation and react with the metal oxide precursors contained in the applied coating. This takes place only in the exposed area. The acid molecules react with the metal oxide precursor and cause a difference in the solubility between exposed and non-exposed areas of the applied coating. The solubility in exposed areas is significantly increased compared to the solubility in unexposed areas. According to the present invention, a significant difference in the solubility of the applied coating in exposed and unexposed areas is achieved when the coating is completely dissolved and removed in the exposed area under the action of a developer solution but the coating remains intact under the action of the same developer solution in the unexposed area. In this way, a direct structuring of the coating surface can take place according to the present invention. According to the present invention, the coating pattern obtained in the course of a direct structuring according to the invention corresponds preferably to a positive photo resin.

Solvents suitable for use in the liquid phase compositions of the present invention are preferably selected from the group consisting of β-diketones, ether alcohols and their derivatives such as esters, alcohols, ethers and esters, nitriles. According to the present invention, the composition used in the present invention may comprise a single solvent or a mixture of two or more solvents. N-Methyl-2-pyrrolidone, ethanol, methanol, 2-propanol, 1-butanol, 1-cyclohexanol and 1-methoxy-2, 2-ethoxyethanol, 2-butoxyethanol, 2- (2-methoxyethoxy) ethanol, ethyl lactate, butyl lactate tetrahydrofurfuryl alcohol, acetylacetone, ethyl acetate, acetonitrile and acetylacetone are particularly preferred solvents which may be used solely or in combination in the present invention.

The liquid phase composition used in the present invention preferably contain the at least one metal oxide precursor as defined above in mass concentrations of from 5 mg/ml to 50 mg/ml, preferably from 5 mg/ml to 30 mg/ml, and most preferably from 7 mg/ml to 25 mg/ml. Depending on the type of the respective metal oxide precursor to be used, different concentrations can be used within which the desired coating can advantageously be produced.

The liquid phase composition used in the present invention comprises the at least one photoacid generator as defined above preferably in mass concentrations from 1 mg/ml to 60 mg/ml, more preferably 1.5 mg/ml to 55 mg/ml, and most preferred from 2 mg/ml to 55 mg/ml.

Preferably, the at least one metal oxide precursor and the at least one photoacid generator are used in such a molar ratio to one another that the at least one photoacid generator, based on the acid molecules releasable under the action of electromagnetic radiation, is present in at least equimolar ratio to the at least one metal oxide precursor in the composition as described herein. Thus, for a photo acid generator or mixture thereof which releases one mole of acid molecule per mole of photo acid generator molecules and is present in the liquid phase composition at a concentration of 10 mol/l, a concentration of 10 mol/l for the respective metal oxide precursor(s) results. For a photo acid generator, which releases two mol of acid molecules per mole of photo acid generator molecules, a concentration of 20 mol/l for the respective metal oxide precursor results in a concentration of 10 mol/l of photo acid generator(s). Preferably the molar ratio of the at least one photo acid generator to the metal oxide precursor in the composition is from 1 to 1 to >1 to 1, more preferably from 1 to 1 to 5 to 1.

More preferably, the at least one metal oxide precursor and the at least one photoacid generator are used in such a mol ratio to one another that the at least one photoacid generator, based on the acid molecules releasable under the action of electromagnetic radiation, is in equimolar ratio to the at least one Metal oxide precursor is contained in the composition as described herein.

The liquid phase composition used in the present invention, in addition to the at least one metal oxide precursor, the at least one photoacid generator and the at least one solvent may comprise further additives. In general, all suitable additives for coating compositions for producing metal oxide layers may be present in the liquid phase composition. Examples of suitable additives are, without limitation, surfactants and foam inhibitors.

For coating of the surface, especially for the coating in step (I) known coating processes can be used, for example, without limitation, from the group consisting of printing processes, spraying processes, rotary coating processes, dipping processes and processes selected from meniscus coating, slit coating, slot-die coating and curtain coating. Production processes according to the invention can comprise one or more successive coating steps, as defined above. By repeated application, coatings with increased layer thickness can be achieved.

After the coating and before performing further process steps, the coated surface can additionally be dried. Corresponding measures and conditions for this purpose are known to those skilled in the art.

The exposure in step (II) can be carried out by methods known and known in the art for this purpose. According to some embodiments, the production process according to the invention is distinguished by the fact that the exposure takes place by means of irradiation with UV, IR or VIS radiation.

Particularly suitable in this context are exposure methods in which electromagnetic radiation can act on the areas of the coating to be exposed by means of halogen lamps, low-pressure mercury vapor lamps, in particular quartz glass low-pressure mercury lamps, or by means of an excimer via a suitable exposure mask. Duration, irradiation dose and wavelength are chosen and adapted as a function of the particular photo acid generator used. Regarding the respective metal oxide precursor used in the coating composition, there is no dependence with regard to irradiation duration, dose and wavelength of the exposure step. Preferably electromagnetic radiation with a wavelength in the range of λ = 100-500 nm is used in step (II).

It is preferred to expose the coated surface to electromagnetic radiation in step (II) for a period of 5 seconds to 5 minutes, preferably 10 seconds to 3 minutes, more preferably about 15 seconds to about 120 seconds.

In order to improve the effectiveness of the acid molecules and improvement of the layer contrast it might be advantageous that the method of the present invention further comprises as step (IV) a thermal treatment of the exposed surface. The thermal treatment preferable applies temperatures equal or above 50 °C, more preferably of from 50 °C to 150 °C. The duration of such a thermal conversion is preferably in the range of from 10 sec. to 5 minutes. The thermal treatment might be done using conventional thermal sources like for example an oven or by using radiation, for example microwave radiation, UV-radiation, IR-radiation or laser beam energy.

The developing step (Step III) is preferably carried out by treating the coating after step (II) or optional step (IV) with a liquid, preferably a developing solution. More preferred development step (III) is carried out by treatment with at least one liquid selected from the group consisting of aqueous bases, aqueous acids, water, alcohols, ketones, esters and mixtures thereof. A preferred developing solution comprises at least one compound selected from the group consisting of ethanol, propanol, 1-methoxy-2-propanol, and mixtures thereof. The most preferred developing solution to be used in step (III) of the process according to the invention comprises or preferably consists of ethanol, dimethyl succinate, ethylene glycol and DMSO.

In a preferred embodiment of the invention the method further comprises as step (V) a step of thermal treatment (conversion) of the developed coating. A thermal treatment according to step (V) is preferably carried out at temperatures above 80 °C, more preferably at or above 150 °C, most preferably at temperatures of above 150 °C to 250 °C. The duration of such a thermal conversion is preferably in the range of from 30 minutes to 90 minutes, most preferred for about 60 minutes.

Instead of a conventional thermal treatment, for example by using an oven, a conversion of the developed coating might also be done by applying electromagnetic radiation, preferably microwave radiation, UV-radiation, IR-radiation or laser beam energy, as step (V). Suitable electromagnetic conversion methods and parameters are known in the art and depend on the nature of the respective metal oxide layer.

The optional step (V) is preferably performed in the presence of oxygen and / or other oxidizing agents, but preferably in the presence of oxygen.

The present invention also relates to a metal oxide-containing layer which has been produced by a process as described herein.

In a last aspect, the present invention is also directed to the use of at least one such metal oxide-containing layer for producing electronic components, in particular for the production of quantum dot based light emitting devices.

All the cited documents are incorporated herein by reference in their entirety. Further embodiments are found in the following examples without the invention being limited to them. It is self-evident and intended that all embodiments disclosed herein in connection with the described compounds be equally applicable to the described uses and methods. Such embodiments are therefore also within the scope of the present invention.

After step (III) or step (IV) a cleaning step (VI) might be performed.

The process steps (I) to (III) and optional (IV), (V) and (VI) might be repeated to deposit multiple patterned first layers onto the first electrode.

The method of the invention preferably further comprises the formation of a layer comprising quantum dots. The layer comprising quantum dots might be deposited before the formation of the first layer or after the formation of the first layer.

The method of the present invention preferably comprises a subsequent step, where a second electrode is deposited over the first layer. Preferably this subsequent step includes forming a layer comprising quantum dots after the deposition of the first layer or after formation of the first layer.

The method of the invention preferably comprises a step of forming a second layer. The forming of the second layer can be done before or after formation of a layer comprising quantum dots. Preferably the formation of the layer comprising quantum dots is performed in a way that the layer comprising quantum dots is arranged between the first and second layers.

The first electrode is preferably deposited on a substrate, the substrate preferably being selected from substrates comprising or preferably consisting of glass, quartz, metal, semiconductor, dielectric, paper, wafer or plastic, the plastic preferably beeing selected from polyethylene (PE), polypropylene (PP), polyethylene terephthalate (PET), polyethylene naphthalate (PEN), polyimide, polyether ether ketone (PEEK) or polyamide. The substrate may be a flexible substrate.

The first electrode can be, for example, a cathode. A cathode can comprise a low work function (e.g., less than 4.0 eV), electron-injecting, metal, such as Al, Ba, Yb, Ca, a lithium-aluminum alloy (Li:Al), a magnesium- silver alloy (Mg:Ag), or lithium fluoride - aluminum (LiF:Al). Other examples of cathode materials include silver, gold, ITO, etc. An electrode, such as Mg:Ag, can optionally be covered with an opaque protective metal layer, for example, a layer of Ag for protecting the cathode layer from atmospheric oxidation, or a relatively thin layer of substantially transparent ITO. An electrode can be sandwiched, sputtered, or evaporated onto the exposed surface of the solid layer. Preferably the cathode comprises silver or aluminium.

The method can further comprise forming of a second device layer over the first layer or the layer comprising the quantum dots. In this embodiment the electrode layer is posited over the second layer. The second layer can also be patterned according to the method used for the patterning of the first layer with multiple coating and patterning steps to form the second layer from multiple charge transport layers that are deposited according to the invention.

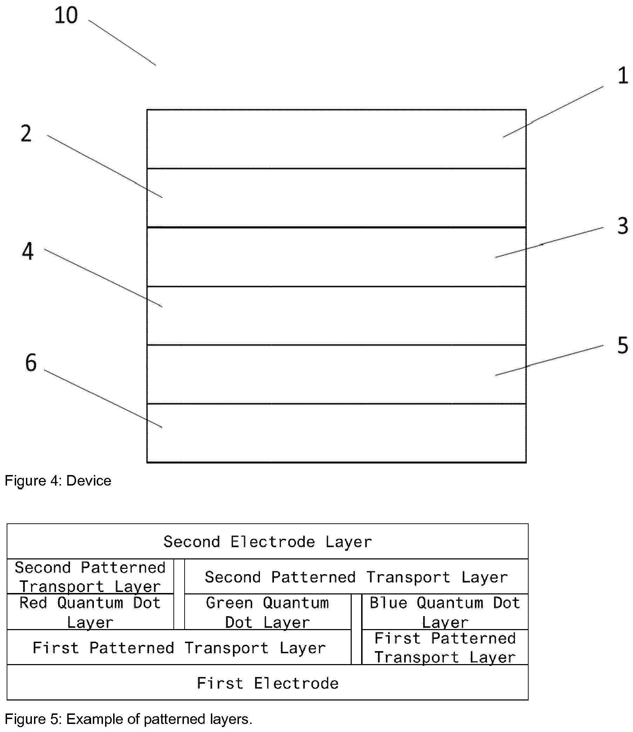

Multiple coating and patterning steps (I-VI) may be necessary to come to a patterned first layer and/or second layer as shown in figure 5. The different patterned layers of one level, e.g. first layers, might have a different chemical composition.

The present invention is preferred directed to a device comprising a first layer comprising a metal oxide, prepared by a method according to the invention. The first layer preferably is a charge transport layer. The device preferably comprises further a layer comprising quantum dots.

Preferably the device of the invention comprises the first layer formed on top of a first electrode, the first layer comprising a metal oxide formed from the liquid phase for producing metal oxide-containing layers that had been patterned by electromagnetic radiation, especially UV radiation, a second electrode over the first layer, and a layer comprising quantum dots disposed between the first layer and one of the two electrodes.

The second electrode can be, for example, an anode. An anode can comprise a high work function (e.g., greater than 4.0 eV) hole-injecting conductor, such as an indium tin oxide (ITO) layer. Other anode materials include other high work function hole-injection conductors including, but not limited to, for example, tungsten, nickel, cobalt, platinum, palladium and their alloys, gallium indium tin oxide, zinc indium tin oxide, titanium nitride, polyaniline, or other high work function hole-injection conducting polymers. An electrode can be light transmissive or transparent. In addition to ITO, examples of other light-transmissive electrode materials include conducting polymers, and other metal oxides, low or high work function metals, conducting epoxy resins, or carbon nanotubes/polymer blends or hybrids that are at least partially light transmissive. An example of a conducting polymer that can be used as an electrode material is poly(ethlyendioxythiophene), sold by Bayer AG under the trade mark PEDOT. Other molecularly altered poly(thiophenes) are also condttcting and could be used, as well as emaraldine salt form of polyaniline. In certain embodiments, the anode comprises aluminum. One or both of the electrodes can be patterned.

It might be advantageous, if the device further includes a second layer, wherein a layer comprising quantum dots is disposed between the first and second layers.

The metal oxide present in the first layer preferably comprises indium oxide, zinc oxide, gallium oxide, yttrium oxide, tin oxide, germanium oxide, scandium oxide, titanium oxide, zirconium oxide, aluminum oxide, wolfram oxide, molybdenum oxide, nickel oxide, chromium oxide, iron oxide, hafnium oxide, tantalum oxide, niobium oxide, or copper oxide, or mixtures thereof. Other metal oxides may be determined to be useful or desirable for inclusion in the first layer. The first layer may also include a mixture of two or more metal oxides prepared as taught herein. In certain preferred embodiments, the metal oxide comprises indium oxide. An example of a metal oxide precursor for indium oxide includes indium oxo alkoxide according to the invention.

The device of the present invention is preferably a light-emitting device or a part of light emitting device.

The first device layer(s) preferably have a thickness in a range from about 1 nm to 500 nm. Other thicknesses may be determined to be useful or desirable based on the particular device architecture and materials included in the device.

Figure 4 provides a schematic representation of an example of one embodiment of a device in accordance with the present invention.
Referring to Figure 4, the depicted example of a device 10 includes a structure (from top to bottom) including a first electrode 1 (e.g., a cathode), a first (charge transport) layer 2 formed by the deposition of a metal oxide precursor composition that can be directly patterned by means of exposure to electromagnetic radiation to form the patterned metal oxide layer in accordance with the invention (e.g., a layer comprising a material capable of transporting electrons (as referred to herein as an "electron transport layer"), a layer comprising quantum dots 3, an optional second (charge transport) layer 4 (e.g., a layer comprising a material capable of transporting or injecting holes (also referred to herein as a "hole transport material"), a second electrode 5 (e.g., an anode), and a substrate 6. A charge injecting layer (e.g., PEDOT:PSS) (now shown) can be disposed for example, between the second electrode and second (charge transport) layer. When voltage is applied across the anode and cathode, the anode injects holes into the hole injecting material while the cathode injects electrons into the electron transport material. The injected holes and injected electrons combine to form an exciton on the quantum dots and emit light.

In an example of another embodiment of a device in accordance with the present invention, a device can include a structure which includes (from top to bottom) an anode, a first (charge transport) layer comprising a material capable of transporting holes (as referred to herein as an "hole transport layer"), a layer comprising quantum dots 3, a second (charge transport) layer comprising a material capable of transporting electrons or injecting (as referred to herein as an "electron transport layer") formed by the deposition of a metal oxide precursor composition that can be directly patterned by means of exposure to electromagnetic radiation to form the patterned metal oxide layer in accordance with the invention, a cathode 5, and a substrate 6. A hole injecting layer (e.g., PEDOT:PSS) (now shown) can be disposed for example, between the anode and first charge transport layer.

Examples of various substrates, other charge transport materials, hole injection materials, electrode materials, quantum dots (e.g., semiconductor nanocrystals), and other additional layers that may be optionally included in a device are described below.

The example of the device illustrated in Figure 4 can be a light emitting device wherein the layer comprising quantum dots comprises an emissive material.

An example of a preferred light emitting device architecture is described in International Application No. PCT/US2009/002123, filed 3 April 2009, by QD Vision, Inc., et al, entitled "Light-Emitting Device Including Quantum Dots", which published as WO2009/123763 on 8 October 2009, which is hereby incorporated herein by reference in its entirely.

Other multilayer structures may optionally be used (see, for example, U.S. Patent Application Nos. 10/400,907 (now U.S. Patent No. 7,332,21 1) and 10/400,908 (now U.S. Patent No. 7,700,200), filed March 28, 2003 each of which is incorporated by reference in its entirety).

A first layer as taught herein can also be included in other types of electronic or optoelectronic devices. Examples of such devices include, but are not limited to, light- emitting devices, thin-film transistors, photodetectors, sensors, as well as photovoltaic cells.

A layer comprising a metal oxide prepared as described herein may further comprise one or more additional sol-gel and/or non-sol-gel films. A non-sol-gel film may be organic, inorganic, hybrids, or mixtures thereof.

It is preferred that the first device layer prepared in accordance with the present invention shows a smooth solid state layer (preferably with a surface roughness (RMS) determined by AFM (Atomic Force Microscopy) less than or equal to 1.5 nm, more preferably less than or equal to 1 nm, at a 500 nm scale)) at a low temperature (e.g., less than 200 °C, less than 185 °C, less than or equal to 150 °C). Such can be beneficial when underlying device layers (e.g., a quantum dot layer) and/or the performance thereof can be sensitive to higher temperatures.
Typically, the metal oxide precursor is converted to a metal oxide at a temperature higher than ambient or room temperature.

A device in accordance with the invention can be fabricated, for example, by a method comprising forming a first device layer comprising a metal oxide by spin-coating a metal oxide precursor composition that can be directly patterned by means of exposure to electromagnetic radiation to form the patterned metal oxide layer on top of already formed layer comprising quantum dots. For example, by baking in air at a temperature that would not harm the light-emitting performance of the quantum dots, a first device layer (e.g., a charge transport layer) described herein can be formed in situ, A layer of conductive contact composed of inactive metal (like Al, Ag, Au, e.g., by thermal decomposition) can be formed thereover or a layer of conductive metal oxides (like ITO, IZO etc.) can be formed thereover(e.g., by sputtering), as top contact, for the device.

For example, a first device layer can be prepared on top of a layer comprising quantum dots (QD Layer) in a partially fabricated device by spin-casting a metal oxide precursor composition that can be directly patterned by means of exposure to electromagnetic radiation to form the patterned metal oxide layer on the QD layer and baking same on a hotplate set at, e.g., 150 °C, in air for about 30 min. (The partial device can further include a hole transport layer (e.g., TFB) under the QD layer and other device layers thereunder, such as, for example, those mentioned in the description of figure 4.) Following heating, the partial device can be moved into a vacuum oven in an inert-gas circulated glovebox to bake at a similar low temperature for another 30 min. Thereafter, in a thermal deposition chamber, a metal cathode contact can be formed thereover by either Ag or Al, or other metals; or a layer of conductive metal oxide is formed by sputtering; or by pasting certain cathode contact like Ag-paste. The device can thereafter preferably be encapsulated. For example, a device can be encapsulated by a cover glass with UV-curable epoxy.

A first layer taught herein that is formed from an indium oxide precursor can comprise a hybrid organic/inorganic electron transport/electron injecting layer in a device.

Depending on the selection of materials used to fabricate the device, such device can be top-emitting, bottom-emitting, or both (e.g., by choosing the transparency of the contact conductors and other device layers).

The device comprising a first layer, preferably a charge transprot layer, prepared according to the method of the invention can have application in commercial products such as, for example, backplanes for organic light emitting diodes, backplanes for quantum dot based light emitting devices, LCD devices, RFID tags, organic sensors, gas sensors, bio sensors, and ASICs.

The electrodes of the device can be connected to a voltage source by electrically conductive pathways.
A quantum dot is a nanometer sized particle that can have optical properties arising from quantum confinement. The particular composition(s), structure, and/or size of a quantum dot can be selected to achieve the desired wavelength of light to be emitted from the quantum dot upon stimulation with a particular excitation source. In essence, quantum dots may be tuned to emit light across the visible spectrum by changing their size. See C.B, Murray, C.R. Kagan, and M.G. Bawendi, Annual Review of Material Sci., 2000, 30: 545-610 hereby incorporated by reference in its entirety. A quantum dot can comprise a core comprising one or more semiconductor materials and a shell comprising one or more semiconductor materials, wherein the shell is disposed over at least a portion, and preferably all, of the outer surface of the core. A quantum dot including a core and shell is also referred to as a "core/shell" structure.
A device can further include a cover, coating or layer over the surface of the device opposite the substrate for protection from the environment (e.g., dust, moisture, and the like) and/or scratching or abrasion. In a further embodiment, the cover can further optionally include a lens, prismatic surface, etc. Anti-reflection, light polarizing, and/or other coatings can also optionally be included over the pattern. Optionally, a sealing material (e.g., UV curable epoxy or other sealant) can be further added around any uncovered edges around the perimeter of the device.

In addition to the charge transport layers, a device may optionally further include one or more charge-injection layers, e.g., a hole-injection layer (either as a separate layer or as part of the hole transport layer) and/or an electron-injection layer (either as a separate layer as part of the electron transport layer). Charge injection layers comprising organic materials can be intrinsic (un-doped) or doped. A hole injecting layer can comprise PEDOT:PSS.

One or more charge blocking layers may further optionally be included. For example, an electron blocking layer (EBL), a hole blocking layer (HBL), or an exciton blocking layer (eBL), can be introduced in the structure. A blocking layer can include, for example, 3-(4-biphenylyl)-4-phenyl-5-tert butylphenyl-1,2,4-triazole (TAZ), 3,4,5- triphenyl-1,2,4-triazole, 3;5-bis(4-tert-butylphenyl)-4-pheny 1-1,2,4-triazole, bathocuproine (BCP), 4,4',4"-tris{N-(3-methylphenyl>-N-phenylamino} triphenylamine (m-MTDATA), polyethylene dioxythiophene (PEDOT), 1,3- bis(5-(4-diphenylamino)phenyl-1,3,4-oxadiazol- 2-yl)benzene, 2-(4-biphenylyl)-5-(4-tertbutylphenyl)- 1,3,4-oxadiazole, 1,3-bis[5-(4-(l,l-dimethylethyl)phenyi)-1,3,4-oxadiazol-5,2-yl)benzene, 1,4-bis(5-(4-diphenylamino)phenyl-1,3,4-oxadiazol-2-yl)benzene, 1,3,5-tris[5-(4-(l,l-dimethylethyl)phenyl)-1,3,4-oxadiazol-2-yl)benzene, or 2,2',2"-(1,3,5-Benztnetriyl)-tris(l-phenyl-1-H-benzimidazole) (TPBi). Charge blocking layers comprising organic materials can be intrinsic (un-doped) or doped.

Charge injection layers (if any), and charge blocking layers (if any) can be deposited by spin coating, dip coating, vapor deposition, or other thin film deposition methods. See, for example, M. C. Schlamp, et al., J. Appl. Phys,, 82, 5837-5842, (1997); V. Santhanam, et al., Langmuir, 19, 7881 -7887, (2003); and X. Lin, et al., J. Phys. Chem. B, 105, 3353-3357, (2001), each of which is incorporated by reference in its entirety.
In some applications, the substrate can further include a backplane. The backplane can include active or passive electronics for controlling or switching power to individual pixels or light-emitting devices. Including a backplane can be useful for applications such as displays, sensors, or imagers. In particular, the backplane can be configured as an active matrix, passive matrix, fixed format, direct drive, or hybrid. The display can be configured for still images, moving images, or lighting. A display including an array of light emitting devices can provide white light, monochrome light, or color-tunable light.

The device of the invention can further include a cover, coating or layer over the surface of the device opposite the substrate for protection from the environment (e.g., dust, moisture, and the like) and/or scratching or abrasion. In a further embodiment, the cover can further optionally include a lens, prismatic surface, etc. Anti-reflection, light polarizing, and/or other coatings can also optionally be included over the pattern. Optionally, a sealing material (e.g., UV curable epoxy or other sealant) can be further added around any uncovered edges around the perimeter of the device.

## Claims

1. A method for preparing a device, the method comprising:
forming a first layer, preferably a charge transport layer, over a first electrode, the layer comprising a metal oxide formed from a liquid phase composition for producing metal oxide-containing layers that can be patterned by means of exposure to electromagnetic radiation, **characterized in that** the composition is containing
i. at least one metal oxide precursor, preferably comprising at least one metal atom from the group consisting of In, Zn, Ga, Y, Sn, Ge, Sc, Ti, Zr, Al, W, Mo, Ni, Cr, Fe, Hf, Ta, Nb and Cu and preferably comprising at least one ligand from the group of oxo-group, hydroxyl-group, alkoxy-group, carboxy-group, β-diketonate-group, halogenide-group, nitrate-group and secondary and primary amine-groups,
ii. at least one photo acid generator, preferably an photo acid generator which upon exposure to electromagnetic radiation releases at least one acid molecule,
iii. at least one solvent, preferably selected from the group comprising β-diketone ether alcohols, alcohol ethers and esters
and is used for forming the first layer.

2. A method according to claim 1, **characterized in that** the molar ratio of the at least one photo acid generator to the metal oxide precursor in the composition is 1 to 1 to >1 to 1, preferably 1 to 1 to 5 to 1.

3. A method according to claim 1 or 2, **characterized in that** forming the first layer is done by the following process steps
(I) coating of the composition on a surface,
(II) exposure of the surface coated with the composition to electromagnetic radiation, preferably selected from UV-, IR, and/or VIS-radiation and
(III) developing of the first layer.

4. A method according to claims 3, **characterized in that** the coating in step (I) is done by a printing process, a spraying process, a rotary coating process, a dipping process, or a process selected from the group consisting of meniscus coating, slit coating, slot-die coating and curtain coating.

5. The method according to claim 3 to 4, **characterized in that** it further comprises after step (II) as step (IV) a thermal treatment of the developed coating, preferably being effected by means of temperatures of from 50 to 100 °C.

6. A method according to any of claims 3 to 5, **characterized in that** the development step (III) is carried out by treatment with at least one liquid selected from the group consisting of aqueous bases, aqueous acids, water, alcohols, ketones, esters and mixtures thereof.

7. The method according to any of claims 3 to 6, **characterized in that** it further comprises as step (V) a thermal treatment of the developed coating after step (III), preferably being effected by means of temperatures above 80 °C.

8. A method according to any of claims 1 to 7, **characterized in that** the method further comprises the formation of a layer comprising quantum dots.

9. A method according to claim 8, **characterized in that** the layer comprising quantum dots is deposited before the formation of the first layer.

10. A method according to claim 8, **characterized in that** the layer comprising quantum dots is deposited after the formation of the first layer.

11. A method according to any of claims 1 to 10, **characterized in that** the method further comprises forming a second layer before or after formation of a layer comprising quantum dots, such that the layer comprising quantum dots is disposed between the first and second layers.

12. A method according to any of claims 1 to 11, **characterized in that** the first electrode is deposited on a substrate, the substrate preferably being selected from substrates comprising or preferably consisting of glass, quartz, metal, semiconductor, dielectric, paper, wafer, polyethylene (PE), polypropylene (PP), polyethylene terephthalate (PET), polyethylene naphthalate (PEN), polyimide, polyether ether ketone PEEK or polyamide.

13. A method according to claim 7, **characterized in that** UV, IR or VIS radiation is applied before, during or after the thermal treatment of step (V)

14. A device comprising a first layer comprising a metal oxide, prepared by a method according to any of the claims 1 to 13.

15. A device according to claim 14, **characterized in that** the device is a light-emitting device.

16. A device according to claim 14 or 15, comprising the first layer formed on top of a first electrode, the first layer comprising a metal oxide formed from the liquid phase for producing metal oxide-containing layers that had been patterned by electromagnetic radiation, especially UV radiation, a second electrode over the first layer, and a layer comprising quantum dots disposed between the first layer and one of the two electrodes.

17. A device according to any of claims 14 to 16, **characterized in that** the metal oxide comprises indium oxide, zinc oxide, gallium oxide, yttrium oxide, tin oxide, germanium oxide, scandium oxide, titanium oxide, zirconium oxide, aluminum oxide, wolfram oxide, molybdenum oxide, nickel oxide, chromium oxide, iron oxide, hafnium oxide, tantalum oxide, niobium oxide or copper oxide, or mixtures thereof.

18. A device according to any of claims 14 to 17, **characterized in that** the first layer is a charge transport layer.

19. A device according to any of claims 14 to 18, **characterized in that** the device further includes a second layer, wherein a layer comprising quantum dots is disposed between the first and second device layers.
